# EUROPÄISCHE PATENTANMELDUNG

(11) **EP 1 669 545 A1**
(43) Veröffentlichungstag der Anmeldung: **14.06.2006**
(21) Anmeldenummer: 04029079.3
(22) Anmeldetag: 08.12.2004
(51) Int. Cl.: F01D 5/18, F23R 3/00, C23C 4/00, F01D 5/28, C23C 28/00

(54) **Schichtsystem, Verwendung und Verfahren zur Herstellung eines Schichtsystems**

(71) Anmelder: SIEMENS AKTIENGESELLSCHAFT, 80333 München (DE)
(72) Erfinder: Klein, Karsten, 14089 Berlin (DE)

(57) **Zusammenfassung**

Schichtsysteme, die bei hohen Temperaturen eingesetzt werden, degradieren bei Verlust der Schicht oft sehr schnell, was zur Schädigung oder Verlust des Bauteils, bestehend aus diesen Schichtsystemen, führt.

Das vorgestellte Schichtsystem (1) weist ein Sicherheitskühlloch (13) auf, das z.B. durch eine Schicht (10) abgedeckt ist, wobei sich das Sicherheitskühlloch (13) öffnet, wenn die Schicht (10) geschädigt wird, so dass das Schichtsystem (1) zusätzlich durch ein das Sicherheitskühlloch (13) durchströmendes Kühlmedium gekühlt wird.

## Beschreibung

Die Erfindung betrifft ein Schichtsystem gemäß Oberbegriff des Anspruchs 1, die Verwendung eines Schichtsystems nach Anspruch 9 und Verfahren zur Herstellung eines Schichtsystems gemäß Anspruch 10, 15.

Bauteile, die bei hohen Temperaturen eingesetzt werden, weisen oft Schutzschichten auf, die das Bauteil gegen Korrosion oder zu hohen Wärmeeintrag schützen.

Während des Einsatzes des Bauteils kann die Schicht jedoch abplatzen oder degradieren, so dass die gewünschte Schutzfunktion nicht mehr erfüllt werden kann. Dies führt zu einer Schädigung des Substrats und ggf. zu einem Versagen des Bauteils. Bei einer Schädigung des Substrats kann das Bauteil ggf. nicht mehr aufgearbeitet werden, d. h. nicht nochmals mit einer neuen Schicht beschichtet werden.

Es ist daher die Aufgabe der Erfindung, ein Schichtsystem, eine Verwendung eines Schichtsystems und Verfahren zur Herstellung eines Schichtsystems aufzuzeigen, das das Problem überwindet.

Die Aufgabe wird gelöst durch ein Schichtsystem gemäß Anspruch 1, bei dem das Schichtsystem zumindest ein Sicherheitskühlloch aufweist, das verschlossen ist und durch die Verwendung eines Schichtsystems mit Sicherheitskühllöchern nach Anspruch 9 und durch Verfahren zur Herstellung eines Schichtsystems gemäß Anspruch 10, 15.

Beim Abplatzen der Schicht im Bereich eines Sicherheitskühllochs wird dieses Kühlloch geöffnet und das Schichtsystem wird in diesem Bereich gekühlt, sodass es zu keiner oder nur zu einer geringen Schädigung unter den Betriebsbedingungen, denen das Schichtsystem ausgesetzt ist, kommt.

In den Unteransprüchen sind weitere vorteilhafte Maßnahmen aufgelistet, die beliebig in vorteilhafter Art und Weise miteinander verknüpft werden können.

### Es zeigen ausschnittsweise und in schematischer Form

- Figur 1 bis 5: Ausführungsbeispiele eines Schichtsystems,
- Figur 6: schematisch die Wirkungsweise der Sicherheitskühllöcher,
- Figur 7 bis 10: Verfahrensschritte zur Herstellung eines erfindungsgemäßen Schichtsystems,
- Figur 11: eine Turbinenschaufel,
- Figur 12: eine Brennkammer und
- Figur 13: eine Gasturbine.

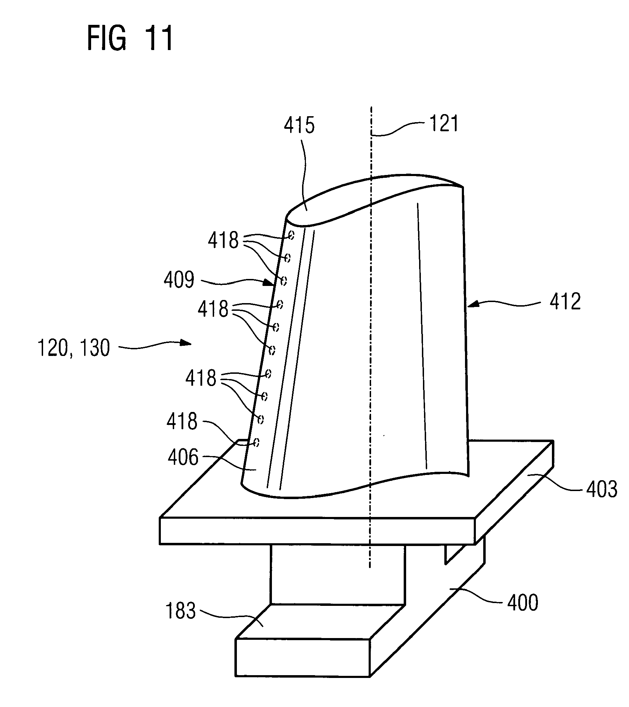

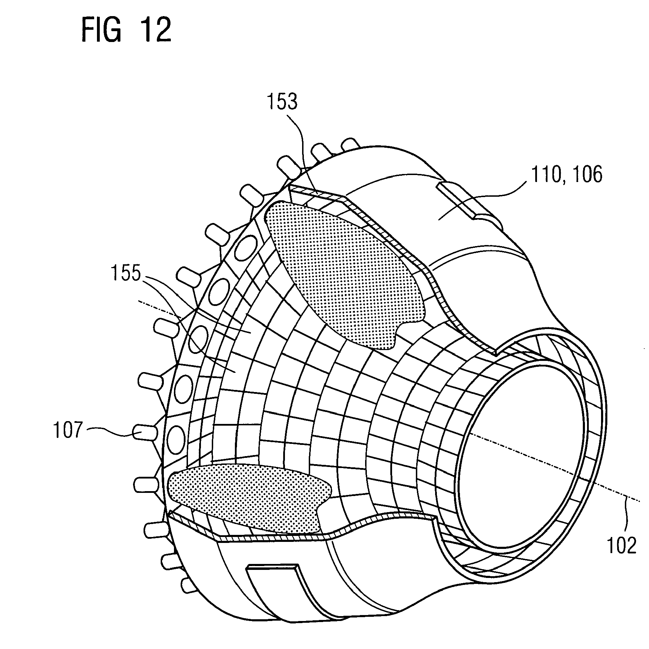

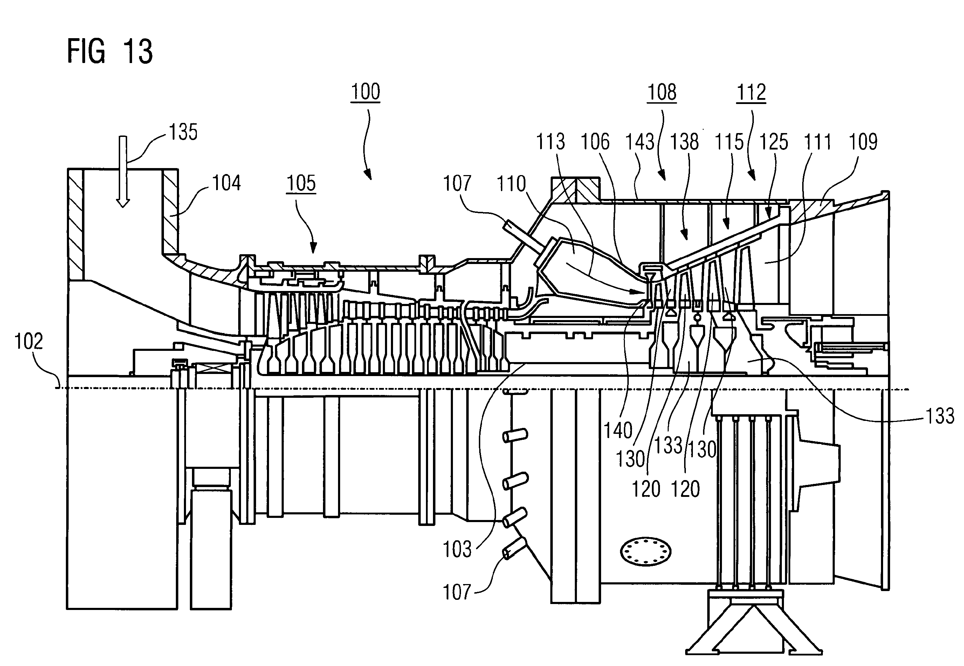

Das Schichtsystem 1 kann ein Bauteil einer Turbine, insbesondere eine Turbinenschaufel 120, 130 (Fig. 11) oder ein Hitzeschildelement 155 (Fig. 12) einer Gas- 100 (Fig. 13) oder Dampfturbine sein.

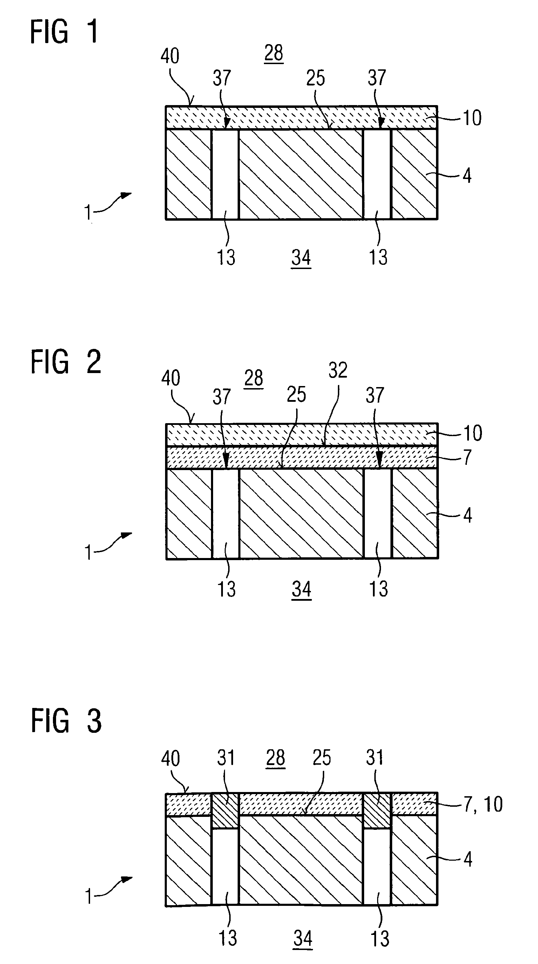

Das Schichtsystem 1 (Figur 1 bis 5) weist ein Substrat 4 auf, das bei Bauteilen für hohe Temperaturen, insbesondere bei Turbinenbauteilen 120, 130, 155 aus einer nickel-, kobalt-oder eisenbasierten Superlegierung besteht.

Figur 1 zeigt ein beispielhaftes erfindungsgemäßes Schichtsystem 1.

In dem Substrat 4 ist zumindest ein Sicherheitskühlloch 13 vorhanden, das sich beispielsweise bis zu einer äußeren Oberfläche 25 des Substrats 4 erstreckt, die einem äußeren Medium, beispielsweise einem Heißgas 28 am nächsten ist. Die Sicherheitskühllöcher 13 werden jedoch bewusst durch eine äußere Schicht 10, beispielsweise eine MCrA1X-Schicht, abgedeckt, d. h. die Öffnungen 37 des Sicherheitskühllochs 13 sind verschlossen durch diese äußere Schicht 10, sodass kein Kühlmedium aus einem Kühlreservoir 34 durch ein Sicherheitskühlloch 13 nach außen 28 dringt.

Unter der Schicht 10 kann noch zumindest eine weitere zwischenliegende Schicht 7 vorhanden sein, sodass die Sicherheitskühllöcher 13 beispielsweise durch zwei Schichten 7 (MCrAlX), 10 (keramische Wärmedämmschicht) verdeckt sind (Fig. 2).
Die zwischenliegende Schicht 7 kann aber auch eine keramische Schicht (z.B. Aluminiumoxid) sein.

In diesen Ausführungsbeispielen (Fig. 1, 2) sind alle Sicherheitskühllöcher 13 verdeckt.

Die Sicherheitskühllöcher 13 können durch eine Schicht 7, 10 verschlossen sein oder durch einen Pin 31 (Fig. 3), der sich in die Schicht 7, 10 und/oder in das Substrat 4 erstreckt. Dieser Pin 31 kann massiv sein und/oder hinein gesteckt werden oder wird beispielsweise durch einen Schlicker erzeugt, der in das Kühlloch eingebracht und gehärtet (gesintert) wird.

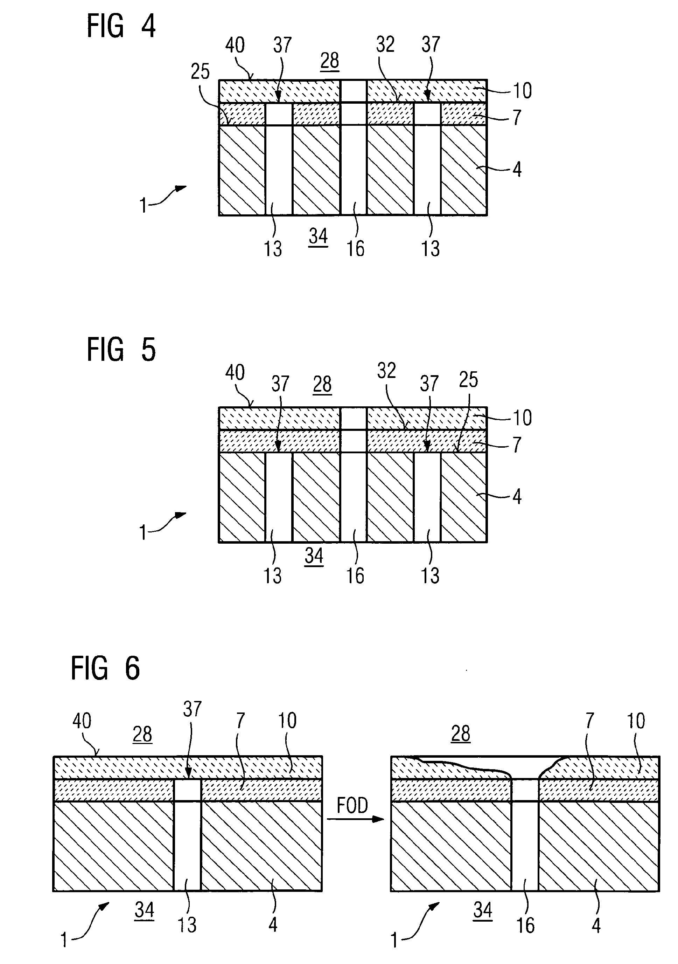

Figur 4 zeigt ein weiteres Ausführungsbeispiel eines erfindungsgemäßen Schichtsystems 1.
In diesem Fall weist das Schichtsystem 1 eine zwischenliegende Schicht 7 und eine weitere, äußere Schicht 10 auf.
Die zwischenliegende Schicht 7 ist beispielsweise eine MCrA1X-Schicht, auf der beispielsweise eine keramische Wärmedämmschicht 10 angeordnet ist.

Die Sicherheitskühllöcher 13, die nur durch eine äußere Schicht 10 verdeckt sind, erstrecken sich hier im Substrat 4 und durch die zwischenliegende Schicht 7 hindurch, d. h. sie grenzen an eine Grenzfläche 32 von Schicht 7 und Schicht 10 an. Ebenso können sich die verdeckten Sicherheitskühllöcher 13 nur bis zur Fläche 25 des Substrats 4 erstrecken (Fig. 5).

Das Schichtsystem 1 (Fig. 4, 5) kann, muss aber nicht, zumindest ein Kühlloch 16, das geöffnet ist, also ein Durchgangsloch darstellt, aufweisen, durch das im normalen Betrieb ein Kühlmedium, beispielsweise Kühlluft aus einem Kühlreservoir strömt.

Figur 6 zeigt die Wirkungsweise der verdeckten Sicherheitskühllöcher 13.

Ein heißes Medium 28 grenzt an die äußere Oberfläche der äußeren Schicht 10 an.
Durch den Einschlag von Fremdpartikeln (Foreign Object Damage, FOD) oder durch Degradation der das Sicherheitskühlloch abdeckenden Schichten 7, 10, hier der Schicht 10 kommt es zum örtlich begrenzten Abplatzen der Schicht 10, wobei dann das Sicherheitskühlloch 13 geöffnet wird oder ein Pin 31 (Fig. 3) sich nicht mehr als Verschluss halten kann. Da das Sicherheitskühlloch 13 ebenso an ein Reservoir 34 eines Kühlmediums angrenzt, strömt dann das Kühlmedium durch das Sicherheitskühlloch 13, das nun ein Kühlloch 16 darstellt.

Die verdeckten Sicherheitskühllöcher 13 werden dort angebracht, wo während des Betriebs des Bauteils 1 aufgrund des Vorhandenseins der Wärmedämmschicht 10 keine zusätzliche oder weitere Filmkühlung notwendig ist. Hingegen würde das eine örtliche Zerstörung der keramischen Wärmedämmschicht 10 zur erhöhten und nicht tolerablen Temperaturerhöhung des Substrats 4 führen.

Dies wird jedoch durch die zusätzliche Kühlung des geöffneten Sicherheitskühllochs 13 verhindert, sodass das Substrat 4 keine unzulässige Schädigung erfährt und/oder wieder verwendet werden kann.

Der durch die Öffnung von Sicherheitskühllöchern 13 etwas erhöhte Verbrauch an Kühlmedium, der zur geringen Verringerung des Wirkungsgrades führt, wird deutlich kompensiert durch dem Vorteil der Nichtschädigung des teuren Substrats 4.

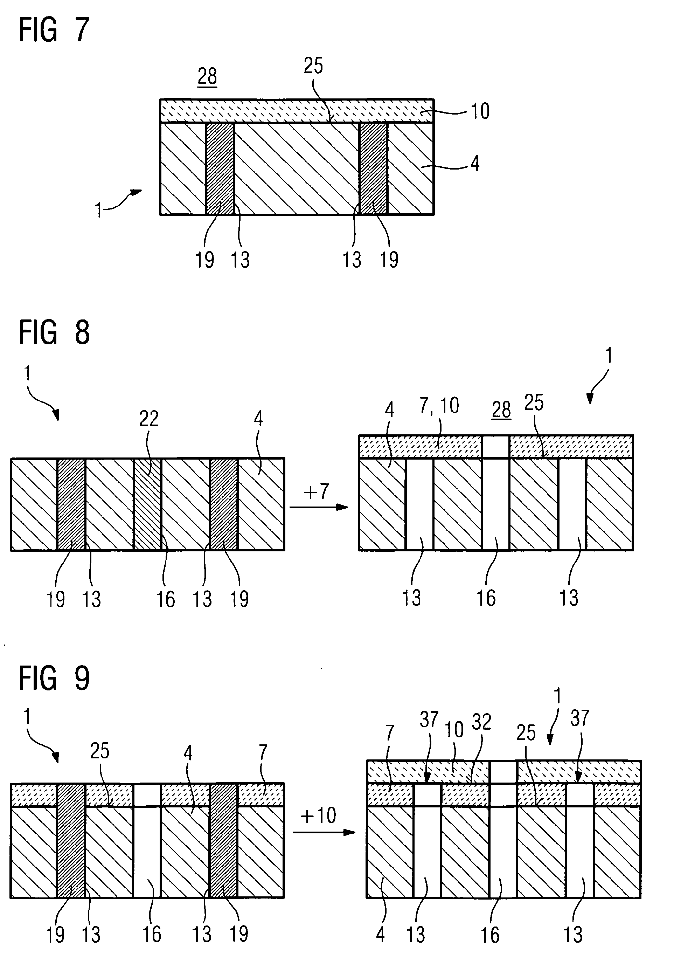

Figur 7 zeigt beispielsweise, wie ein erfindungsgemäßes Schichtsystem 1 hergestellt werden kann.

In das Substrat 4 werden Löcher (Durchgangslöcher) eingebracht, die Sicherheitskühllöcher 13 und ggf. andere Kühllöcher 16, die im normalen Betrieb des Substrats 4 benutzt werden sollen, ergeben sollen.
Je nach Beschichtungsverfahren kann (muss aber nicht) ein Loch mit einem Maskiermittel 19 ausgefüllt werden, das verhindert, dass das Material der Schicht 10 in das Loch eindringt und dieses verstopft.
Das Maskiermittel 19 muss nur die Beschichtungstemperaturen für die Beschichtung der Schicht 10 aushalten und kann danach beispielsweise durch Verdampfen oder Auslaugen entfernt werden. Gegebenenfalls wird noch eine weitere Schicht aufgebracht.

Figur 8 zeigt eine weitere Möglichkeit das erfindungsgemäße Schichtsystem 1 herzustellen.
Das Schichtsystem 1 weist Sicherheitskühllöcher 13 auf, die verdeckt sind, und zumindest ein Kühlloch 16, das geöffnet bleibt.
In die Löcher der herzustellenden Sicherheitskühllöcher 13 wird ein Maskiermittel 19 eingebracht, auf das oder über das sich das Material der aufzubringenden Schicht 7, 10 abscheiden kann.
Hingegen wird in ein Loch 16, das geöffnet bleiben soll, beispielsweise ein Antihaft-Maskiermittel 22 eingebracht, auf dem sich das Material der Beschichtung 7, 10 nicht abscheidet (Fig. 8 rechts), sodass ein Kühlloch 16 gebildet wird.

Figur 9 zeigt eine weitere Variante um ein erfindungsgemäßes Schichtsystem 1 herzustellen.

Hier wurde beispielsweise das Substrat 4 mit der Beschichtung 7 so hergestellt, dass in alle herzustellenden Sicherheitskühllöcher 13 und Kühllöcher 16 ein Antihaft-Maskiermittel 22 eingebracht wurde, oder dass das Substrat 4 mit der Schicht 7 beschichtet wurde und dass danach Löcher im Bereich der herzustellenden Sicherheitskühllöcher 13 und herzustellenden Kühllöcher 16 in die Schicht 7 und in das Substrat 4 eingebracht wurden.

Danach werden die herzustellenden Sicherheitskühllöcher 13 mit einem Maskiermittel 19 gefüllt (Fig. 9), wohingegen das herzustellende Kühlloch 16 nicht mit einem Maskiermittel oder mit einem Antihaft-Maskiermittel 22 gefüllt wird.

Bei der Aufbringung der äußeren Schicht 10 werden die Löcher überdeckt und bilden in gewünschter Weise Sicherheitskühllöcher 13 und ein Loch bleibt als Kühlloch 16 offen.

Ebenso können die offen bleibenden Kühllöcher 16 überdeckt und durch Abtragen von Material, beispielsweise durch Laserstrahlen oder Elektronenstrahlen, oberhalb der zu offen bleibenden Kühllöcher 16 wieder geöffnet werden.

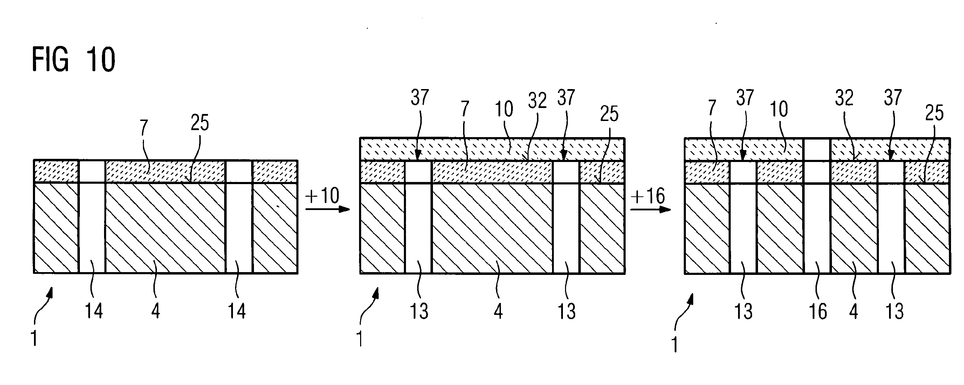

Figur 10 zeigt eine weitere Möglichkeit ein erfindungsgemäßes Schichtsystem 1 herzustellen.

Dabei wird in einem ersten Verfahrensschritt ein Substrat 4 mit einer Schicht 7 beschichtet, wobei dann durch die Schicht 7 und das Substrat 4 hindurch Durchgangslöcher 14 erzeugt werden. Ebenso können vor der Beschichtung mit der Schicht 7 in dem Substrat 4 Durchgangslöcher 14 erzeugt werden, wobei dann bei der Beschichtung mit der Schicht 7 kein Material oberhalb der Durchgangslöcher 14 aufgetragen wird, sodass das Durchgangsloch 14 sich auch nach der Beschichtung des Substrats 4 mit der Schicht 7 durch die Schicht 7 hindurch erstreckt.

In einem weiteren Verfahrensschritt wird eine weitere Schicht, beispielsweise eine äußere Schicht 10 aufgebracht, die die Durchgangslöcher 14 nun überdeckt, wobei beispielsweise Durchgangslöcher 14 mit Maskiermittel 14 gefüllt waren oder ein Gas aus den Durchgangslöchern während der Beschichtung reinströmt, und so Sicherheitskühllöcher 13 bilden.

Insbesondere beim EB-PVD-Verfahren braucht kein Maskiermittel verwendet werden.

In einem der letzten Verfahrensschritte wird in die Schicht 7, 10 und das Substrat 4 das durchgehende Filmkühlloch 16 eingebracht.

Das Verfahren kann entsprechend angewendet werden, wenn nur eine einzige äußere Schicht 10 auf einem Substrat 4 vorhanden sein soll, d.h. in dem Substrat 4 werden Durchgangslöcher 14 erzeugt und die eine Schicht 10 wird aufgebracht, die die Durchgangslöcher 14 im Substrat 4 überdeckt, wobei danach zumindest ein Durchgangsloch 14 in die eine äußere Schicht und das Substrat 4 eingebracht wird.

Figur 11 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf.
Als Leitschaufel 130 kann die Schaufel 130 an ihrer Schaufelspitze 415 eine weitere Plattform aufweisen (nicht dargestellt) .

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung. Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind Teil der Offenbarung.

Ebenso können die Schaufeln 120, 130 Beschichtungen (als Teil des erfindungsgemäßen Schichtsystems) gegen Korrosion oder Oxidation aufweisen (beispielsweise MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein und besteht beispielsweise aus ZrO₂, Y₂O₄- d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) und Sicherheitskühllöcher 13 auf.

Die Figur 12 zeigt eine Brennkammer 110 einer Gasturbine 100. Die Brennkammer 110 ist beispielsweise als so genannte Ringbrennkammer ausgestaltet, bei der eine Vielzahl von in Umfangsrichtung um die Rotationsachse 102 herum angeordneten Brennern 107 in einen gemeinsamen Brennkammerraum münden. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 ist arbeitsmediumsseitig mit einer besonders hitzebeständigen Schutzschicht (beispielsweise als Teil eines erfindungsgemäßen Schichtsystems) ausgestattet oder aus hochtemperaturbeständigem Material gefertigt. Dies können massive keramische Steine oder Legierungen mit MCrAlX und/oder keramischen Beschichtungen sein. Die Materialien der Brennkammerwand und deren Beschichtungen können ähnlich der Turbinenschaufeln sein.

Aufgrund der hohen Temperaturen im Inneren der Brennkammer 110 kann zudem für die Hitzeschildelemente 155 bzw. für deren Halteelemente ein Kühlsystem vorgesehen sein oder die Anordnung mit den Hitzeschildelementen 155 und/oder die Hitzeschildelementen 155 selber weisen beispielsweise Kühllöcher 16 und Sicherheitskühllöcher 13 auf.

Die Figur 13 zeigt beispielhaft eine Gasturbine 100 in einem Längsteilschnitt.
Die Gasturbine 100 weist im Inneren einen um eine Rotationsachse 102 drehgelagerten Rotor 103 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.

Die Ringbrennkammer 106 kommuniziert mit einem beispielsweise ringförmigen Heißgaskanal 111. Dort bilden beispielsweise vier hintereinander geschaltete Turbinenstufen 112 die Turbine 108. Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind. An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.

Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAlX kann noch eine Wärmedämmschicht vorhanden sein, und besteht beispielsweise aus ZrO₂ Y₂O₄-ZrO₂, d.h. sie ist nicht, teilweise oder vollständig stabilisiert durch Yttriumoxid und/oder Kalziumoxid und/oder Magnesiumoxid. Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

## Patentansprüche

1. Schichtsystem (1),
zumindest bestehend aus
einem Substrat (4),
zumindest einer Schicht (7, 10),
**dadurch gekennzeichnet, dass**
in dem Substrat (4) zumindest ein als Sicherheitskühlloch (13) ausgebildetes Durchgangsloch angeordnet ist, dessen Durchgang verschlossen ist.

2. Schichtsystem nach Anspruch 1,
**dadurch gekennzeichnet, dass**
alle Löcher im Substrat (4) als Sicherheitskühllöcher (13) verschlossen sind.

3. Schichtsystem nach Anspruch 1,
**dadurch gekennzeichnet, dass**
das Schichtsystem (1) Sicherheitskühllöcher (13) und zumindest ein oder mehrere Kühllöcher (16) aufweist.

4. Schichtsystem nach Anspruch 1, 2 oder 3,
**dadurch gekennzeichnet, dass**
das Sicherheitskühlloch (13) durch eine einzige Schicht (7, 10) verschlossen ist.

5. Schichtsystem nach Anspruch 1, 2 oder 3,
**dadurch gekennzeichnet, dass**
das Sicherheitskühlloch (13) durch zumindest eine zwischenliegende Schicht (7) und eine äußere Schicht (10) verschlossen ist.

6. Schichtsystem nach Anspruch 1, 2, 3, 4 oder 5,
**dadurch gekennzeichnet,**
**dass** das Substrat (4) eine nickel-, kobalt- oder eisenbasierte Superlegierung ist, und
**dass** die Schicht (7) insbesondere eine MCrAlX-Schicht und dass die Schicht (10) insbesondere eine keramische Wärmedämmschicht ist.

7. Schichtsystem nach Anspruch 1 oder 6,
**dadurch gekennzeichnet, dass**
das Schichtsystem (1) ein Bauteil einer Turbine, insbesondere eine Turbinenschaufel (120, 130) oder ein Hitzeschildelement (155),
insbesondere einer Dampf- oder Gasturbine (100) ist.

8. Schichtsystem nach Anspruch 1,
**dadurch gekennzeichnet, dass**
das Sicherheitskühlloch (13) im Substrat (4) und/oder in der zumindest einen Schicht (7, 10) durch einen Pin (31) verschlossen ist,
wobei der Pin (31) bei Beschädigung der zumindest einen Schicht (7, 10) im Bereich des Sicherheitskühllochs (13) unter den Betriebsbedingungen des Schichtsystems selbsttätig seine Verschlussposition verlässt und das Sicherheitskühlloch (13) für ein Kühlmittel öffnet.

9. Verwendung eines Schichtsystems (1) nach einem oder mehreren der Ansprüche 1 - 8 für den Einsatz in einer Turbine (100),
insbesondere bei einer Turbinenschaufel (120, 130) oder einem Hitzeschildelement (155).

10. Verfahren zur Herstellung eines Schichtsystems (1), insbesondere nach einem oder mehreren der Ansprüche 1 - 7,
**dadurch gekennzeichnet,**
**dass** in die herzustellenden Sicherheitskühllöcher (13) im Substrat (4) oder
im Substrat (4) mit zwischenliegender Schicht (7) ein Maskiermittel (19) gefüllt wird, und
**dass** auf die Oberfläche (25, 34) des Substrats (4) oder der zwischenliegenden Schicht (7) und über die gefüllten herzustellenden Sicherheitskühllöcher (13) eine Schicht (7, 10) aufgebracht wird,
sodass dann die verschlossenen Sicherheitskühllöcher (13) gebildet sind.

11. Verfahren nach Anspruch 10,
**dadurch gekennzeichnet,**
**dass** in die herzustellenden Sicherheitskühllöcher (13) ein Maskiermittel (19) eingebracht wird,
auf oder über das sich eine Schicht (7, 10) abscheiden kann, und
**dass** in das Kühlloch (16), das geöffnet bleibt,
ein Antihaft-Maskiermittel (22) eingebracht wird,
auf dem sich das Material der Schicht (7, 10) nicht abscheidet.

12. Verfahren nach Anspruch 10,
**dadurch gekennzeichnet,**
**dass** in die herzustellenden Sicherheitskühllöcher (13) ein Maskiermittel (19) eingebracht wird,
auf oder über das sich eine Schicht (7, 10) abscheiden kann, und
**dass** in das Kühlloch (16),
das geöffnet bleibt,
kein Maskiermittel eingebracht wird.

13. Verfahren nach Anspruch 10, 11 oder 12,
**dadurch gekennzeichnet,**
**dass** in dem Substrat (4) mit seiner zwischenliegenden Schicht (7),
die herzustellenden Sicherheitskühllöcher (13) auch durch die Schicht (7) hindurch erstrecken, und
**dass** in das offen bleibende Kühlloch (16) ein Antihaft-Maskiermittel (22) eingebracht wird,
und **dass** dann auf die Schicht (7) eine weitere Schicht, insbesondere eine äußere Schicht (10) aufgebracht wird, die die Sicherheitslöcher (13) abdeckt.

14. Verfahren nach Anspruch 10, 11, 12 oder 13,
**dadurch gekennzeichnet, dass**
das Maskiermittel (19, 22),
das das Kühlloch (13, 16) während der Beschichtung verschlossen hat,
entfernt wird,
wobei das Material der Schicht (7, 10) über dem Sicherheitskühlloch (13) verbleibt.

15. Verfahren zur Herstellung eines Schichtsystems (1), insbesondere nach einem oder mehreren der Ansprüche 1 - 7,
**dadurch gekennzeichnet,**
**dass** ein Substrat (4) mit einer Schicht (7) zur Verfügung gestellt wird,
das Löcher durch das Substrat (4) und die Schicht (7) aufweist,
wobei in einem weiteren Verfahrensschritt eine weitere, insbesondere eine äußere Schicht (10) aufgebracht wird, die diese Löcher überdeckt und verschließt und so Sicherheitskühllöcher (13) erzeugt, und
**dass** in einem weiteren Verfahrensschritt zumindest ein durch die zumindest eine Schicht (7, 10) und das Substrat (4) hindurchgehendes Kühlloch (16) erzeugt wird,
das insbesondere zur Filmkühlung dient.
